Europäisches Patentamt

European Patent Office

Office européen des brevets

(19)

(11) Publication number: **0 098 164**
**B1**

(12) **EUROPEAN PATENT SPECIFICATION**

(45) Date of publication of patent specification: **11.01.89**

(51) Int. Cl.⁴: **G 11 C 11/40**

(21) Application number: **83303761.7**

(22) Date of filing: **29.06.83**

(54) **Static type semiconductor memory device.**

(30) Priority: **30.06.82 JP 111519/82**
**30.06.82 JP 111523/82**
**30.06.82 JP 111535/82**

(43) Date of publication of application:
**11.01.84 Bulletin 84/02**

(45) Publication of the grant of the patent:
**11.01.89 Bulletin 89/02**

(84) Designated Contracting States:
**DE FR GB**

(56) References cited:
**EP-A-0 043 245**
**FR-A-2 184 865**
**US-A-3 859 637**
**US-A-4 328 558**

**PATENTS ABSTRACTS OF JAPAN, vol. 4, no. 62 (P-10)544r, 9th May 1980; & JP - A - 55 32207**

(73) Proprietor: **FUJITSU LIMITED**
**1015, Kamikodanaka Nakahara-ku**
**Kawasaki-shi Kanagawa 211 (JP)**

(72) Inventor: **Oritani, Atushi**
**37-22 Nakakibogaoka Asahi-ku**
**Yokohama-shi Kanagawa 214 (JP)**

(74) Representative: **Rackham, Stephen Neil et al**
**GILL JENNINGS & EVERY 53-64 Chancery Lane**
**London WC2A 1HN (GB)**

## Description

The present invention relates to metal-oxide semiconductor (MOS) static-type semiconductor memory device.

Generally, in an MOS static-type semiconductor memory device, one static-type memory cell constructed as a flip-flop is provided at each intersection of word line and bit line pairs, and one word line and one bit line are selected by address means, such as row address buffers, row address decoders, column address buffers, column address decoders, and the like, so that one memory cell is selected. In this case, the actual selection of one word line is performed by a word-line driver clock signal after the row address decoders determine a selected row. Thus, when one word line is selected, a large number of non-selected memory cells connected to the selected word line are also electrically connected to corresponding bit line pairs. For example, in a 16K bit memory, 127 non-selected memory cells are electrically connected to corresponding bit lines. As a result, current flows from the corresponding bit lines into these memory cells. The dissipation of power of a static-type semiconductor memory device is mainly due to the driving of such a bit line load.

In the prior art, in a selected state, i.e., after external signals (such as a row access strobe signal) are received, the word-line driver clock signal becomes high so that at least one of the word lines is always in a selected state. Therefore, the dissipation of power is very large.

On the other hand, the bit line pairs are connected, via load transistors, to a power supply. Therefore, in a non-selected mode, the bit line pairs are charged at a predetermined potential by the power supply. Contrary to this, in a selected mode, such as a read mode, memory cells connected to a selected word line are electrically connected to the corresponding bit line pairs so that current flows from the bit lines into the memory cells. As the result, a difference in potential between the bit lines is generated, the difference in potential is sensed or amplified by a sense amplifier, and data output is transmitted, via an output buffer, to the exterior. At this time, in order to generate a suitable difference in potential between the bit lines, a suitable relationship is formed between the value $g_m$ of the transistors within the memory cells and the value $g_m$ of the load transistors. Therefore, it is impossible to increase or decrease the value $g_m$ of the load transistors.

One example of a static RAM is described in EP—A—0043245 which discloses a static-type semiconductor memory device comprising:

first and second power supply terminals;
a plurality of word lines;
a plurality of pairs of bit lines;
a plurality of load means, each connected to one of said bit lines and to said first power supply terminal, for charging said bit lines;
a plurality of static memory cells each connected to one of said word lines and to one pair of said bit lines;
a row-addressing means for selecting one of said word lines upon the receipt of row-address information;
a column-addressing means for selecting one of said bit line pairs upon the receipt of column-address information;
a sense amplifier for amplifying the difference in potential between a pair of bit lines selected by said column-addressing means;
an output buffer, connected to the output of said sense amplifier, for maintaining and outputting a data output signal; and
a first clock signal-generating circuit for detecting the change of said row-address information and generating a first clock signal.

Recently, much progress has been made in the integration MOS static-type semiconductor memory devices, and, accordingly, the size of the memory cells has been reduced. In this case, naturally, since the value $g_m$ of the transistors within the memory cells is reduced, the value $g_m$ of the load transistors is also reduced. However, since the capacity of the bit lines is large, the driving power of the memory cells for the bit lines is relatively small. Thus, the speed of change of the bit line potential is not as great as it could be and this reduces the read operation speed.

US—A—3859637 discloses a memory cell array in which peripheral circuitry is down powered once a word line has been stably selected by a primary latching circuit.

FR—A—2184865 discloses a dynamic memory cell array which includes a second clock signal generating circuit for resetting a word line driver so that the data in the memory can be refreshed.

The invention is defined in claim 1.

The present invention provides a static-type semiconductor memory device in which the dissipation of power is reduced and the read operation speed is enhanced. Since the word-line driver clock signal is generated only during a predetermined time period after the change of address information. That is, the selection time period of a word line is reduced and, accordingly, the current flowing from the bit lines into the memory cells is also reduced. Thus, the dissipation of power is reduced. In addition, even in a previous read cycle, when the selection time period passes, the potential of each bit line remains high. Therefore, the read operation speed is dependent upon only the change of one bit line potential from a high level to a low level, which change further helps to enhance the read operation speed.

The present invention will now be described and contrasted with the prior art with reference to the accompanying drawings, wherein:—

Figure 1 is a block diagram of an embodiment of a static-type semiconductor memory device;

Figure 2 is a circuit diagram of the memory cells $C_{00}$, $C_{01}$, $C_{10}$, and $C_{11}$ shown in Figure 1;

Figures 3A to 3I are timing diagrams illustrating the signals appearing in the circuit shown in Figure 1;

Figures 4A and 4B are timing diagrams illustrating the read operation of the prior art device;

Figures 5A and 5B are timing diagrams illustrating read operation according to the present invention;

Figure 6 is a circuit diagram of the word line driver WD shown in Figure 1;

Figure 7A is a circuit diagram of the clock signal-generating circuit $CK_1$ shown in Figure 1;

Figure 7B is a logic circuit diagram of the signal-generating circuit PG1 shown in Figure 7A;

Figure 7C is a timing diagram illustrating the signals appearing in the circuit shown in Figure 7B;

Figure 8A is a block diagram of the clock signal-generating circuit $CK_2$ shown in Figure 1;

Figure 8B is a logic circuit diagram of the signal-generating circuit PG2 shown in Figure 8A;

Figure 9 is a block diagram of another embodiment of a static-type semiconductor memory device according to the present invention;

Figures 10A to 10C are timing diagrams illustrating the read operation of the prior art;

Figures 11A to 11D are timing diagrams illustrating the read operation in accordance with the present invention; and,

Figure 12 is a circuit diagram of the output buffer OB shown in Figure 9.

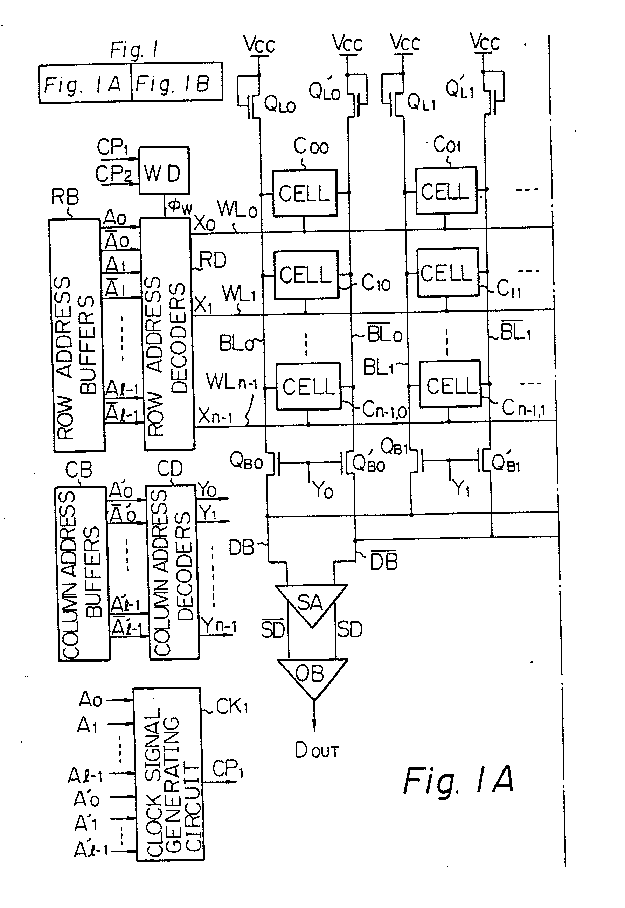

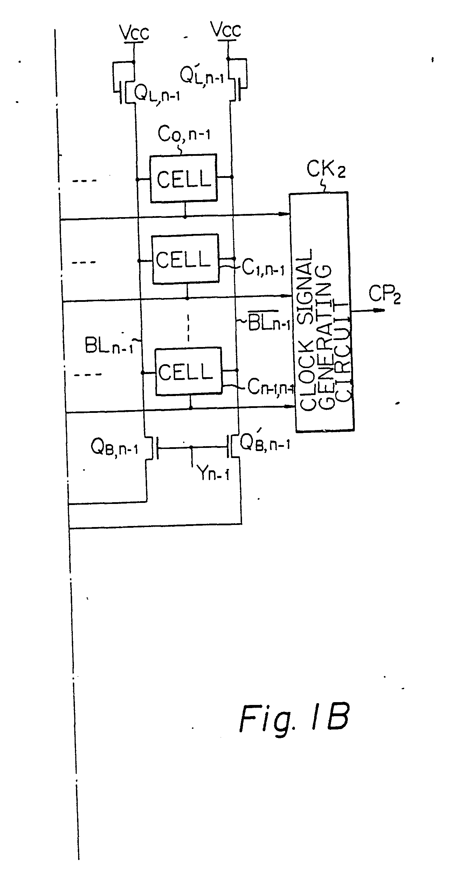

In Fig. 1, which illustrates one embodiment of the present invention, known static-type memory cells $C_{ij}$ (i,j=0, 1, - - -, n−1) are arranged in an n-row, n-column, matrix. Each memory cell is connected to one word line and a pair of bit lines. For example, a memory cell $C_{00}$ is connected to a word line $WL_0$ and to bit lines $BL_0$ and $\overline{BL_0}$. Selection of the word lines $WL_0$, $WL_1$, - - -, $WL_{n−1}$ is performed by the row-selection signals $X_0$, $X_1$, - - -, $X_{n−1}$ of row address decoders RD. In this case, the row address decoders RD decode the address signals $A_0$, $\overline{A_0}$, $A_1$, $\overline{A_1}$, - - -, $A_{l−1}$, $\overline{A_{l−1}}$ ($2^l$=n). However, the generation of above-mentioned row-selection signals $X_0$, $X_1$, - - -, $X_{n−1}$ requires the generation of a word-line driver clock signal $\phi_W$ of a word line driver WD. In addition, the bit lines $BL_0$, $\overline{BL_0}$, $BL_1$, $\overline{BL_1}$, - - -, $BL_{n−1}$, $\overline{BL_{n−1}}$ are connected to column-selection gates $Q_{B0}$, $Q_{B0}'$, $Q_{B1}$, $Q_{B1}'$, - - -, $Q_{B,n−1}$, $Q_{B,n−1}'$, respectively, and each gate pair is controlled by column-selection signals $Y_0$, $Y_1$, - - -, $Y_{n−1}$. That is, the selection of the bit line pairs is performed by the column-selection signals $Y_0$, $Y_1$, - - -, $Y_{n−1}$ of column address decoders CD, and, in this case, the column address decoders CD decode the address signals $A_0'$, $\overline{A_0}'$, - - -, $A_{l−1}'$, $\overline{A_{l−1}}'$. A pair of bit lines is connected, via selected column-selection gates, to data bit lines DB and $\overline{DB}$. A sense amplifier SA is connected to the data bit lines DB and $\overline{DB}$, and an output buffer OB is connected to the outputs of the sense amplifier SA.

The word line driver WD is set by the rise of a clock signal $CP_1$ of a clock signal-generating circuit $CK_1$ and is reset by the rise of a clock signal $CP_2$ of a clock signal-generating circuit $CK_2$. The clock signal-generating circuit $CK_1$ detects the change of the address signals $A_0$, $A_1$, - - -, $A_{l−1}$,

$A_0'$, $A_1'$, - - -, $A_{l−1}'$ and generates the clock signal $CP_1$ while the clock signal-generating circuit $CP_2$ detects the rise of the row-selection signals $X_0$, $X_1$, - - -, $X_{n−1}$. The clock signal-generating circuit $CK_2$ is located at the terminals of the word lines $WL_0$, $WL_1$, - - -, $WL_{n−1}$ on the opposite side of the row address decoders RD. That is, the clock signal-generating circuit $CK_2$ detects the timing of a row-selection signal when it propagates to the terminal of the corresponding word line, with the result that the clock signal $CP_2$ is generated.

In Fig. 1, $Q_{L0}$, $Q_{L0}'$, $Q_{L1}$, $Q_{L1}'$, - - -, $Q_{L,n−1}$, $Q_{L,n−1}'$ designate load transistors connected between the bit lines $BL_0$, $\overline{BL_0}$, $BL_1$, $\overline{BL_1}$, - - -, $BL_{n−1}$, $\overline{BL_{n−1}}$, and a power supply $V_{CC}$. These load transistors are used for charging the bit lines.

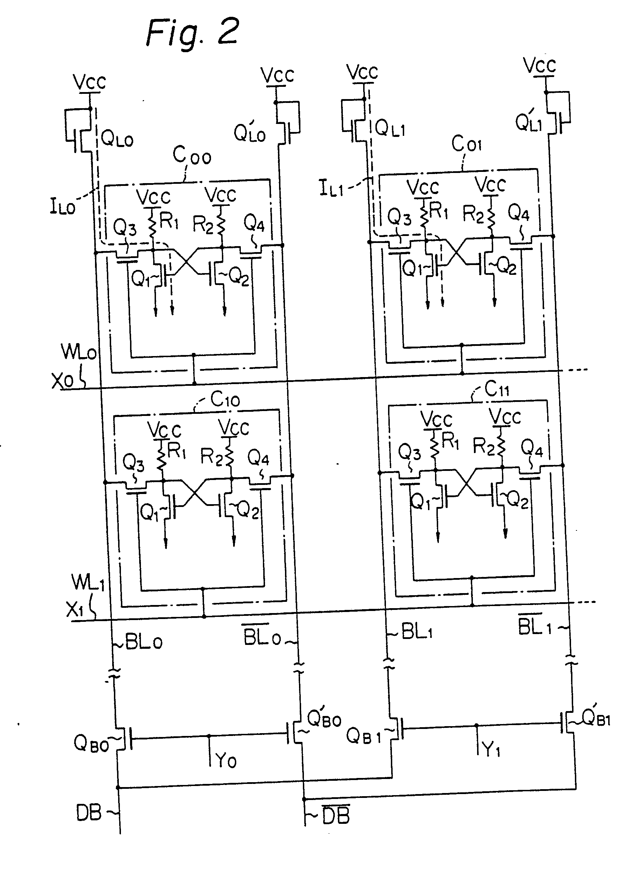

In Fig. 2, which is a circuit diagram of the memory cells $C_{00}$, $C_{01}$, $C_{10}$, and $C_{11}$ of Fig. 1, each memory cell comprises loads $R_1$ and $R_2$, cross-coupled driver transistors $Q_1$ and $Q_2$ constituting a flip-flop, and transfer gate transistors $Q_3$ and $Q_4$. The transfer gate transistors $Q_3$ and $Q_4$ are connected to the bit lines $BL_0$ and $\overline{BL_0}$ (or $BL_1$ and $\overline{BL_1}$), respectively. These transistors are turned on and off by the row-selection signal $X_0$ (or $X_1$) at the word line $WL_0$ (or $WL_1$). For example, when the row-selection signal $X_0$ is high, a current $I_{L0}$ flows from the bit line $BL_0$ to the on-state transistor $Q_1$ of the memory cell $C_{00}$, and a current $I_{L1}$ flows from the bit line $BL_1$ to the on-state transistor $Q_1$ of the memory cell $C_{01}$. That is, in this case, even when the memory cell $C_{00}$ is selected, a current flows through the non-selected memory cell $C_{01}$. In a 16K bit memory, the number of such non-selected cells is 127. Therefore, a reduction of the above-mentioned current is advantageous in respect to the dissipation of power. In the present invention, even when a word line such as $WL_0$ is in a selected state, the duration of the high potential of the row-selection signal $X_0$ is limited so as to reduce the dissipation of power.

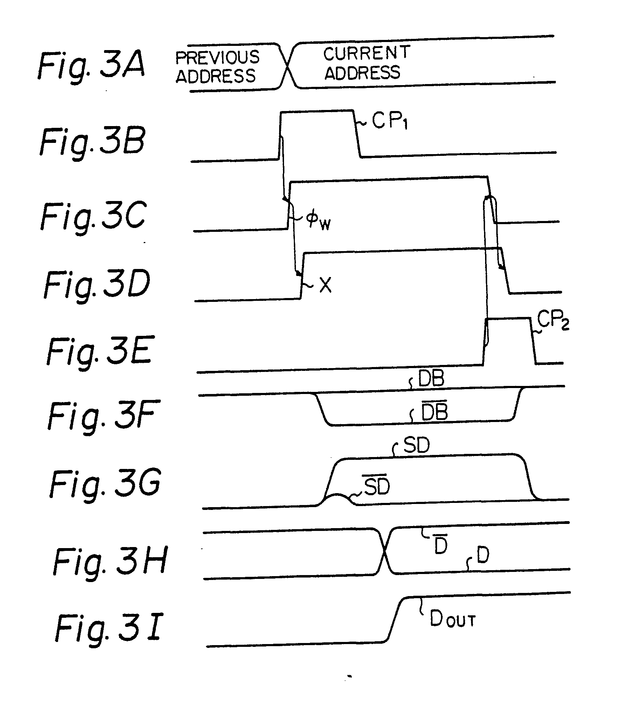

Referring back to Fig. 1, the operation of the circuit thereof is explained with reference to Figs. 3A through 3I. As is illustrated in Fig. 3A, when one of the address signals $A_0$, $A_1$, - - -, $A_{l−1}$, $A_0'$, $A_1'$, - - -, $A_{l−1}'$ changes, the clock signal-generating circuit $CK_1$ detects such a change and generates the clock signal $CP_1$ shown in Fig. 3B. As a result, the word-line driver WD is set so as to generate the word-line driver clock signal $\phi_W$, and, subsequently, the row-selection signal of a selected word line is changed as shown in Fig. 3D. Thus, as the selecting operation proceeds, the potential at the terminal of the selected word line is changed from low to high. The clock signal-generating circuit $CK_2$ detects such a change and generates a clock signal $CP_2$ as shown in Fig. 3E. As a result, the word line driver WD is reset, and, accordingly, the word-line driver clock signal $\phi_W$ becomes low as shown in Fig. 3D. Therefore, the selected state of a word line is maintained only between the rise of the clock signal $CP_1$ and the rise of the clock signal $CP_2$.

During the above-mentioned time period, the selected bit line pair is connected, by one of the

column-selection signals $Y_0$, $Y_1$, - - -, $Y_{n-1}$, to the data bit line pair DB and $\overline{DB}$, whose potentials change as shown in Fig. 3F. The potentials of the data bit line pair DB and $\overline{DB}$ are amplified by the sense amplifier SA, which, in turn, generates sense data SD and $\overline{SD}$. The sense data SD and $\overline{SD}$ are maintained in a latch circuit of the output buffer OB. The data of the latch circuit, defined by D and $\overline{D}$, are shown in Fig. 3H, and the data output $D_{OUT}$ of the output buffer OB is shown in Fig. 3I. That is, since the determination of the data D and $\overline{D}$ of the latch circuit is performed between the rise of the clock signals $CP_1$ and the rise of the clock signal $CP_2$, it is unnecessary to maintain the selected state of a word line after the generation of the clock signal $CP_2$. In view of this, in the present invention, the selected state of a word line is no longer maintained after the generation of the clock signal $CP_2$, thereby reducing the dissipation of power of the memory cells.

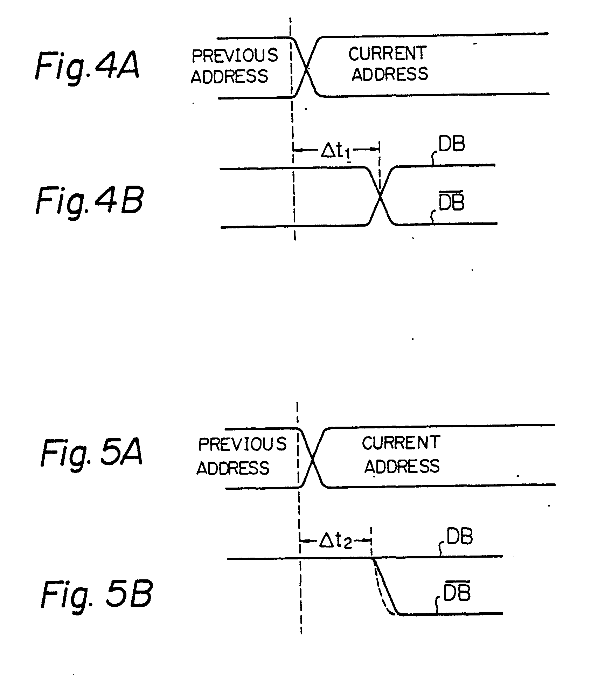

It should be noted that the potentials of the data bit lines DB and $\overline{DB}$ are both high at the end of the previous address cycle since the word-line driver clock signal $\phi_W$ remains low, thereby helping to enhance the read operation speed, which is explained with reference to Figs. 4A, 4B, 5A, and 5B. That is, in the prior art, in a selected mode, the word-line driver clock signal $\phi_W$ always remains high, and, accordingly, the potential of one of the data bit lines DB and $\overline{DB}$ is high while the potential of the other is low. Therefore, if the address is changed as shown in Fig. 4A, the potentials of the data bit lines DB and $\overline{DB}$ may be reversed as shown in Fig. 4B. In this case, the read operation speed is dependent upon the time period $\Delta t_1$ determined by the intersection of the potentials of the data bit lines DB and $\overline{DB}$. On the contrary, in the present invention, when the address is changed as shown in Fig. 5A, only one of the potentials of the data bit lines DB and $\overline{DB}$ is changed from high to low. In this case, the read operation speed is dependent upon the time period $\Delta t_2$ determined by the point of separation of the potentials of the data bit lines DB and $\overline{DB}$. Thus, the read operation speed is improved as compared with the prior art. ·

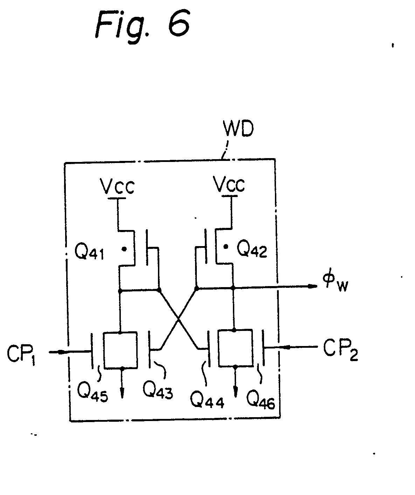

Next, the configuration of each portion of the circuit of Fig. 1 is explained with reference to Figs. 6, 7A, 7B, 8A, and 8B.

In Fig. 6, which illustrates the word line driver WD of Fig. 1, $Q_{41}$ and $Q_{42}$ are load transistors, $Q_{43}$ and $Q_{44}$ are transistors constituting a flip-flop, and $Q_{45}$ and $Q_{46}$ are input transistors. That is, the clock signal $CP_1$ serves as a set signal, and the clock signal $CP_2$ serves as a reset signal. Therefore, the word-line driver clock signal $\phi_W$ is set by the rise of the clock signal $CP_1$ and is reset by the rise of the clock signal $CP_2$.

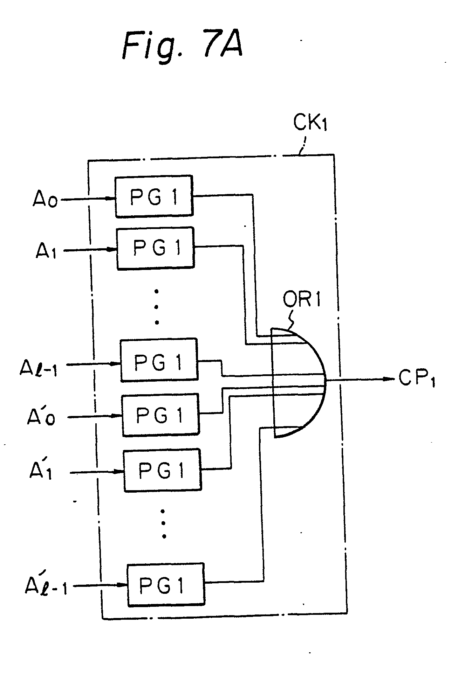

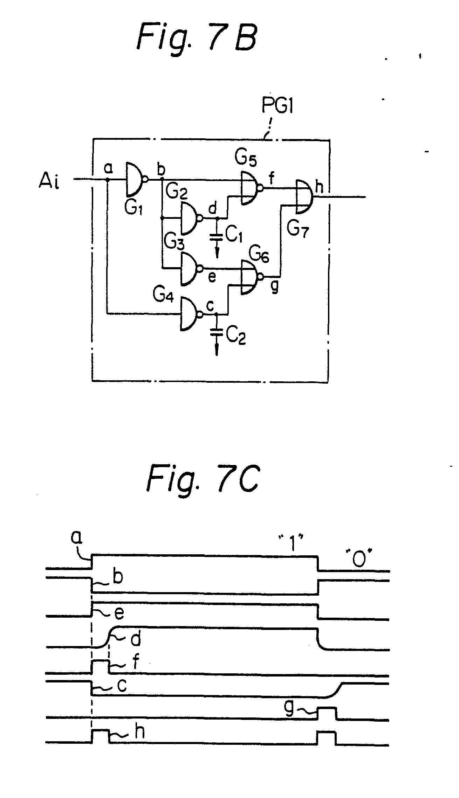

In Fig. 7A, which illustrates the clock signal-generating circuit $CK_1$ of Fig. 1, the clock signal-generating circuit $CK_1$ comprises a plurality of signal-generating circuits PG1, corresponding to each of the address signals $A_0$, $A_1$, - - -, $A_{l-1}$, $A_0'$, $A_1'$, - - -, $A_{l-1}'$, and an OR gate OR1. The signal-generating circuits PG1 detect a change of the address signal and generate a pulse having a predetermined time period. For example, as is illustrated in Fig. 7B, the signal-generating circuit PG1 comprises NAND gates $G_1$ through $G_4$, NOR gates $G_5$ and $G_6$, an OR gate $G_7$, and capacitors $C_1$ and $C_2$. In this case, the gates $G_1$, $G_2$, and $G_5$ and the capacitor $C_1$ form a rise-detecting circuit, and the gates $G_1$, $G_3$, $G_4$, and $G_6$ and the capacitor $C_2$ form a fall-detecting circuit. Therefore, the output of the gate $G_7$ detects the rise and fall of the address signal $A_l$, i.e., the change thereof, and generates the signal $CP_1$. In more detail, referring to Fig. 7C, the address signal $A_l$ (node a) is changed from "1" to "0", the output b of the NAND gate $G_1$ changes and the output d of the NAND gate $G_2$ is an inverted signal of the signal b, which is delayed a little by the capacitor $C_1$. As a result, the output f of the NOR gate $G_5$ is a pulse which is generated by the rise of the address signal $A_l$. Similarly, the output g of the NOR gate $G_6$ is a signal which is generated by the fall of the address signal $A_l$. Therefore, the output h of the OR gate $G_7$, which combines the signal f with the signal g, is a clock signal which is generated by the change of the address signal $A_l$.

In Fig. 7A, such a signal-generating circuit PG1 as illustrated in Fig. 7B is provided for each address signal, and, accordingly, the clock signal-generating circuit $CK_1$ generates a clock signal $CP_1$ when any one of the address signals is changed.

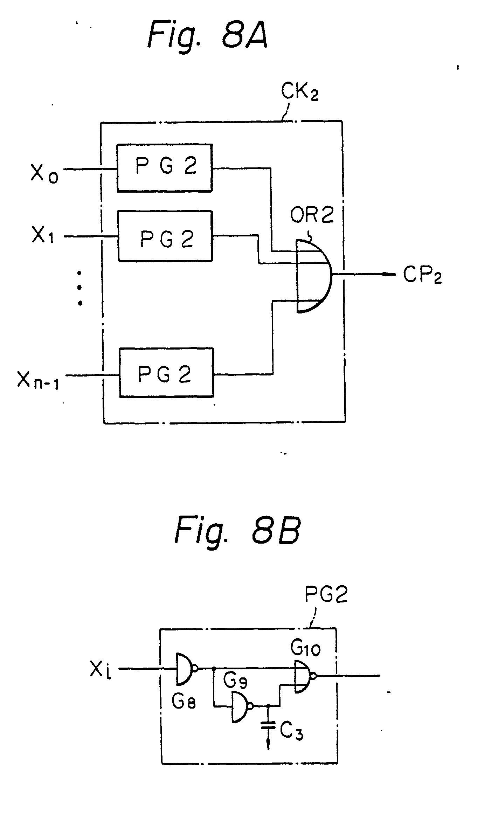

In Fig. 8a, which illustrates the clock signal-generating circuit $CK_2$ of Fig. 1, the clock signal-generating circuit $CK_2$ comprises a plurality of signal-generating circuits PG2, corresponding to the row address signals $X_1$, $X_2$, - - -, $X_{n-1}$, and an OR gate OR2. The signal-generating circuits PG2 detect a rise in the address signal and generate a signal having a predetermined time period. The signal-generating circuit PG2 shown in Fig. 8B comprises NAND gates $G_8$, $G_9$, an OR gate $G_{10}$, and a capacitor $C_3$.

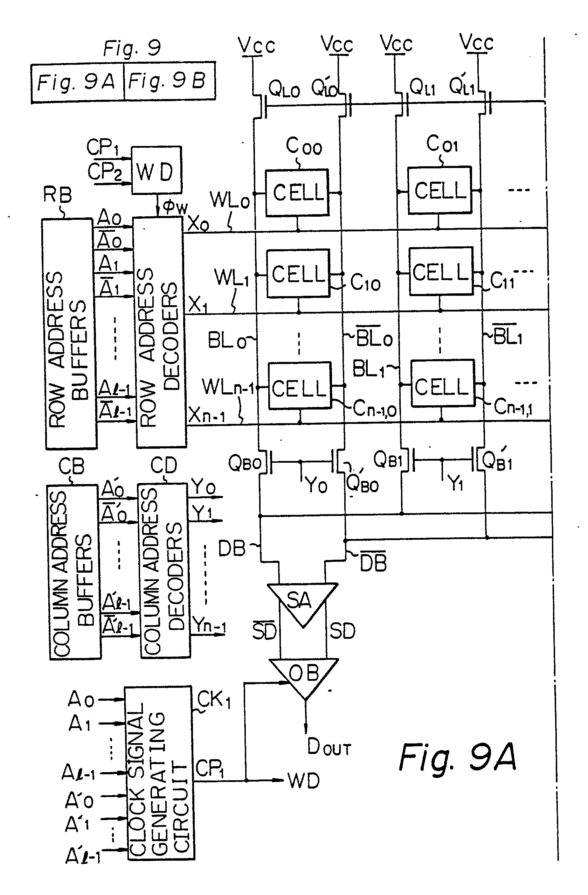

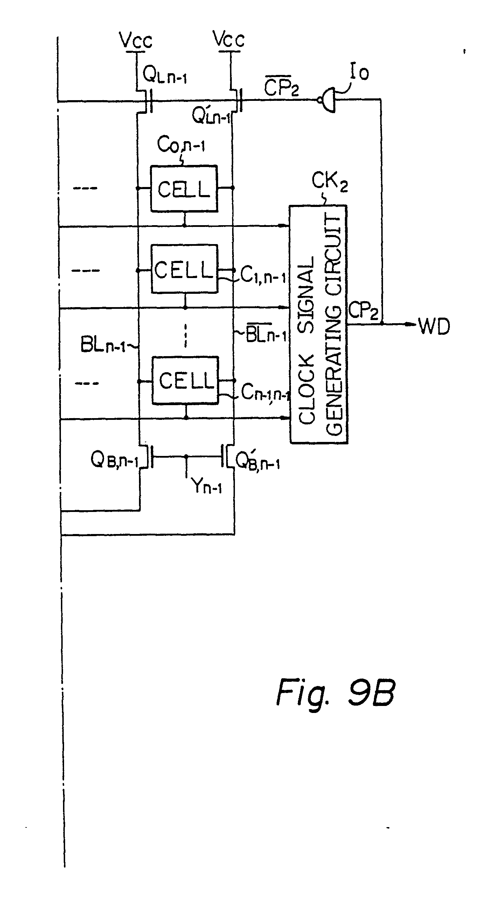

In Fig. 9, which illustrates another embodiment of the present invention, the output buffer OB is controlled by the block signal $CP_1$ of the clock signal-generating circuit $CK_1$, and the load transistors $Q_{L0}$, $Q_{L0}'$, $Q_{L1}$, $Q_{L1}'$, - - -, $Q_{L,n-1}$, $Q_{L,n-1}'$ are controlled by an inverted signal $\overline{CP_2}$ of the clock signal $CP_2$ of the clock signal-generating circuit $CK_2$. In this case, the signal $\overline{CP_2}$ is obtained by an inverter $I_0$.

The clock signal $CP_1$ controls the output buffer OB so that the data output $D_{OUT}$ thereof is temporarily maintained at a high level when an address is changed and thereafter to obtain an essentially effective data output so as to enhance the read operation speed.

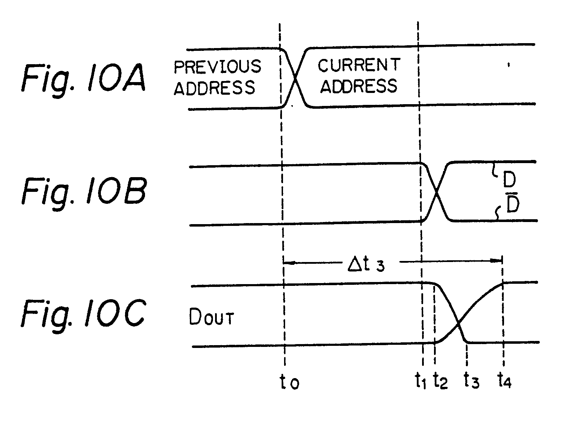

First, the operation of the output buffer OB without being controlled by the clock signal-generating circuit $CK_1$ is explained with reference to Figs. 10A, 10B, and 10C. That is, at a time $t_0$, the potential of the address changes as shown in Fig. 10A, and after that, at a time $t_1$, the potentials of the latch data D and $\overline{D}$ of the output buffer OB are changed. Of course in this case, even when the address is changed, the potentials of the sense data SD and $\overline{SD}$ (Fig. 9) are not changed if the data is the same. When the potentials of the latch data D and $\overline{D}$ are changed, the potential at the data output $D_{OUT}$ of the output buffer changes at a time $t_2$. However, if the capacity of the output load is large, the change from a high level to a low level terminates at a time $t_3$ while the change from a low level to a high level terminates at a time $t_4$. That is, this difference is due to the difference between the charging operation and the discharging operation for the output load capacity. Therefore, the read operation speed is dependent upon the time period $\Delta t_3$, which is relatively long.

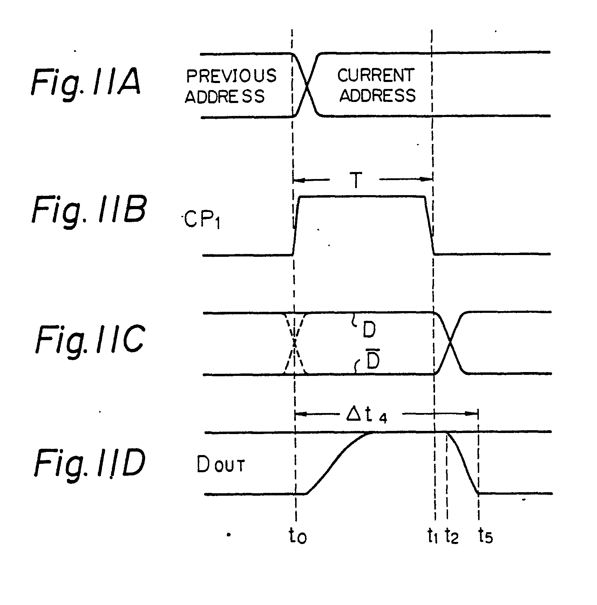

On the contrary, in the output buffer OB being controlled by the clock signal-generating circuit $CK_1$, after the change of the address, the data output $D_{OUT}$ of the output buffer is maintained at a high level for a predetermined time period regardless of the potentials of the sense data SD and $\overline{SD}$ of the sense amplifier SA. That is, as is shown in Figs. 11A and 11B, the clock signal $CP_1$ is generated during a predetermined time period T after the time $t_0$ when the address is changed. By using this clock signal $CP_1$, the latch data D is caused to assume a high level and the latch data $\overline{D}$ is caused to assume a low level, as is shown in Fig. 11C. Therefore, the data output $D_{OUT}$ of the output buffer is pushed up or maintained regardless of the potential of the sense data SD and $\overline{SD}$, as is illustrated in Fig. 11D. After that, at a time $t_2$, the potential of the data output $D_{OUT}$ changes. However, as is illustrated in Fig. 11D, this potential changes only from a high level to a low level. Therefore, the read operation speed is dependent upon the time period $\Delta t_4$ and, accordingly, is high.

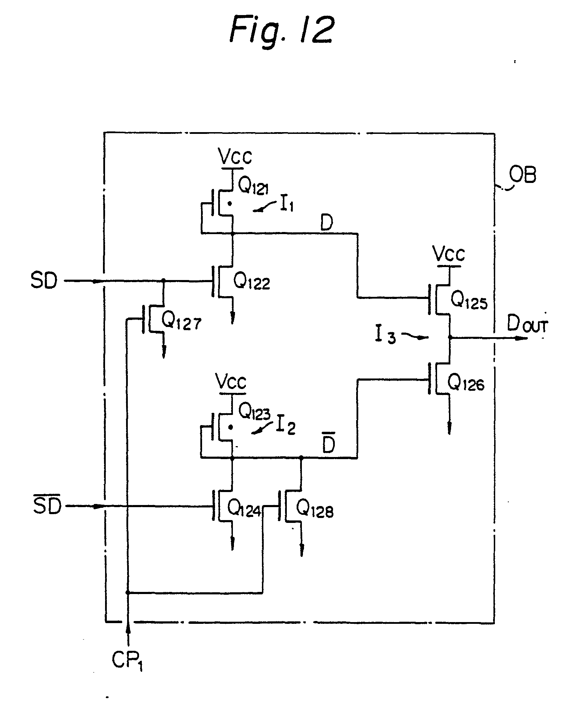

In Fig. 12, which illustrates the output buffer OB of Fig. 9, the sense data SD is supplied to an inverter $I_1$ formed by a depletion-type transistor $Q_{121}$ and an enhancement-type transistor $Q_{122}$ while the sense data SD is supplied to an inverter $I_2$ formed by a depletion-type transistor $Q_{123}$ and an enhancement-type transistor $Q_{124}$. In addition, the output of the inverter $I_1$ is connected to a charging transistor $Q_{125}$ of an inverter $I_3$, and the output of the inverter $I_2$ is a discharging transistor $Q_{126}$ of the inverter $I_3$. Further, a transistor $Q_{127}$ is connected to the input side of the inverter $I_1$, and a transistor $Q_{128}$ is connected to the output of the inverter $I_2$. These transistors $Q_{127}$ and $Q_{128}$ are controlled by the clock signal $CP_1$ of the clock signal-generating circuit $CK_1$.

First, a case where the clock signal $CP_1$ is at a low level is explained. The potential of the sense data $\overline{SD}$ is inverted by the inverter $I_1$, and the potential of the sense data $\overline{SD}$ is inverted by the inverter $I_2$. Therefore, usually, since the sense data SD is at a high level while the sense data SD is at a low level or vice versa, one of the transistors $Q_{125}$ and $Q_{126}$ is in an on-state while the other is in an off-state. For example, when the transistors $Q_{125}$ is in an on-state, the data output $D_{OUT}$ becomes high due to the charging operation of the transistor $Q_5$. On the other hand, when the transistor $Q_{126}$ is in an on-state, the data output

$D_{OUT}$ becomes low due to the discharging operation of the transistor $Q_{126}$. That is, the potential of the data output $D_{OUT}$ changes in accordance with a change in the potential of the sense data SD and $\overline{SD}$.

When the clock signal $CP_1$ is at a high level, the transistor $Q_{127}$ is turned on so that the input of the inverter $I_1$ becomes low while the output of the inverter $I_1$ becomes high. As a result, the transistor $Q_{125}$ is turned on. That is, the charging transistor $Q_{125}$ is turned on regardless of the potential of the sense data SD. Simultaneously, since the transistor $Q_{128}$ is turned on, the output of the inverter $I_2$ becomes low, and, accordingly, the discharging transistor $Q_{126}$ is turned off. That is, the discharging transistor $Q_{126}$ is turned off regardless of the potential of the sense data $\overline{SD}$. As a result the data output $D_{OUT}$ becomes high.

Next, the operation of the load transistors $Q_{L0}$, $Q_{L0}'$, $Q_{L1}$, $Q_{L1}'$, - - -, $Q_{L,n-1}$, $Q_{L,n-1}'$ of Fig. 9 is explained. That is, when the signal $\overline{CP_2}$ is low, the load transistors are cut off. As a result, the bit lines $BL_0$, $\overline{BL_0}$, $BL_1$, $\overline{BL_1}$, - - -, $BL_{n-1}$, $\overline{BL_{n-1}}$ are disconnected from the power supply $V_{CC}$ for a predetermined time period. In this case, therefore, the charging operation for the bit lines is suspended to increase the driving power of the memory cells for the bit lines. Thus, in the read mode, since the bit lines $BL_0$, $\overline{BL_0}$, $BL_1$, $\overline{BL_1}$, - - -, $BL_{n-1}$, $\overline{BL_{n-1}}$ are disconnected from the power supply $V_{CC}$, the difference in potential between the bit lines is rapidly increased, as is indicated by the dotted line in Fig. 5B, thereby improving the read operation speed.

Note that the above-mentioned control of the load transistors is effective particularly when the memory cells located near the clock signal-generating circuit are selected since the signal $\overline{CP_2}$ begins to fall after the terminal potential of a word line rises.

## Claims

1. A static-type semiconductor memory device comprising:

first and second power supply terminals ($V_{CC}$, $V_{SS}$);

a plurality of word lines ($WL_0$ to $WL_{n-1}$);

a plurality of pairs of bit lines $BL_0$, $\overline{BL_0}$, - - -);

a plurality of load means ($Q_{L0}$, $Q_{L0}'$, - - -), each connected to one of said bit lines and to said first power supply terminal, for charging said bit lines;

a plurality of static memory cells ($C_{00}$, $C_{01}$, - - -) each connected to one of said word lines and to one pair of said bit lines;

a row-addressing means (RB, RD) for selecting one of said word lines upon the receipt of row-address information;

a column-addressing means (CB, CD) for selecting one of said bit line pairs upon the receipt of column-address information;

a sense amplifier (SA) for amplifying the difference in potential between a pair of bit lines selected by said column-addressing means;

an output buffer (OB), connected to the output of said sense amplifier, for maintaining and outputting a data output signal ($D_{OUT}$); and

a first clock signal-generating circuit ($CK_1$) for detecting the change of said row-address information and generating a first clock signal ($CP_1$);

characterised in that the first clock signal-generating circuit ($CK_1$) also detects a change of said column address information;

in that the memory device also includes:

a second clock signal-generating circuit ($CK_2$) for detecting the change of the potential of said word lines and generating a second clock signal ($CP_2$); and

a word driver (WD) for activating said row-addressing means, said word driver being set by the rise of said first clock signal and reset by the rise of said second clock signal;

said row-addressing means and said second clock signal-generating circuit being disposed opposite to each other and said word lines being disposed therebetween.

2. A device according to claim 1, wherein said output buffer is controlled by said first clock signal, said output buffer generating a high potential signal upon the receipt of said first clock signal, which is high regardless of the output potential of said sense amplifier.

3. A device according to claim 1 or 2, further comprising an inverter means ($I_0$), connected between the output of said second clock signal-generating circuit and said load means, for cutting off said load means upon the receipt of a low inverted signal ($CP_2$) of said second clock signal.

**Patentansprüche**

1. Statische Halbeiterspeichvervorrichtung mit:
ersten und zweiten Energieversorgungsanschlüssen ($V_{CC}$, $V_{SS}$);
einer Vielzahl von Wortleitungen ($WL_0$ bis $WL_{n-1}$);
einer Vielzahl von Paaren von Bitleitungen $BL_0$, $\overline{BL_0}$, - - -);
einer Vielzahl von Lasteinrichtungen ($Q_{L0}$, $Q_{L0}'$, - - -), die jeweils mit einer der genannten Bitleitungen und mit dem genannten ersten Energieversorgungsanschluß verbunden sind, um die genannten Bitleitungen zu laden;
einer Vielzahl von statischen Speicherzellen ($C_{00}$, $C_{01}$, - - -), die jeweils mit einer der genannten Wortleitungen und mit einem Paar der genannten Bitleitungen verbunden sind;
einer Reihenadressiereinrichtung (RB, RD), zum Auswählen einer der genannten Wortleitungen nach Empfang einer Reihenadressinformation;
einer Spaltenadressiereinrichtung (CB, CD) zum Auswählen eines von den genannten Bitleitungspaaren nach Empfang der Spaltenadressinformation;
einem Leseverstärker (SA) zum Verstärken der Potentialdifferenz zwischen einem Paar von Bitleitungen, welches durch die genannte Spaltenadressiereinrichtung ausgewählt ist;
einem Ausgangspuffer (OB), der mit dem Ausgang des genannten Leseverstärkers verbunden ist, um ein Datenausgangssignal ($D_{OUT}$) aufrechtzuerhalten und auszugeben; und

einem ersten Taktsignalgeneratorkreis ($CK_1$) zum Detektieren der Änderung der Reihenadressinformation und zum Generieren eines ersten Taktsignals ($CP_1$);

dadurch gekennzeichnet, daß der erste Taktsignalgeneratorkreis ($CK_1$) auch eine Änderung der genannten Spaltenadressinformation detektiert;

daß die Speichervorrichtung ferner enthält:

einen zweiten Taktsignalgeneratorkreis ($CK_2$) zum Detektieren der Änderung des Potentials der genannten Wortleitungen und zum Erzeugen eines zweiten Taktsignals ($CP_2$); und

einen Worttreiber (WD) zum Aktivieren der genannten Reihenadressiereinrichtung, welcher Worttreiber durch den Anstieg des genannten ersten Taktsignals gesetzt und durch den Anstieg des genannten zweiten Taktsignals zurückgesetzt wird;

die genannten Reihenadressiereinrichtung und der genannte zweite Taktsignalgeneratorkreis einander gegenüber angeordnet und die genannten Wortleitungen dazwischen angeordnet sind.

2. Vorrichtung nach Anspruch 1, bei der der genannte Ausgangspuffer durch das genannte erste Taktsignal gesteuert wird, der genannte Ausgangspuffer ein Hochpotentialsignal nach Empfang des genannten ersten Taktsignals erzeugt, welches unabhängig von dem Ausgangspotential des genannten Leseverstärkers hoch ist.

3. Vorrichtung nach Anspruch 1 oder 2, ferner mit einer Invertereinrichtung ($I_0$), die zwischen dem Ausgang des genannten zweiten Taktsignalgeneratorkreises und der genannten Lasteinrichtung angeschlosen ist, um die genannte Lasteinrichtung nach Empfang eines niedrigen invertierten Signals ($CP_2$) des zweiten Taktsignals abzutrennen.

**Revendications**

1. Dispositif de mémoire à semi-conducteur du type statique comportant:
une première et une seconde bornes d'alimentation ($V_{CC}$, $V_{SS}$); .
plusieurs lignes de mots ($WL_0$ à $WL_{n-1}$);
plusieurs paires de lignes de bits ($BL_0$, $\overline{BL_0}$, . . .);
plusieurs dispositifs de charge ($Q_{L0}$, $Q_{L0}'$, . . .), connectés chacun à l'une desdites lignes de bits et à ladite première borne d'alimentation pour charger lesdites lignes de bits;
plusieurs cellules de mémoire statique ($C_{00}$, $C_{01}$, . . .) connectées chacune à l'une desdites lignes de mots et à une paire desdites lignes de bits;
un dispositif d'adressage de rangées (RB, RD) destiné à sélectionner l'une desdites lignes de mots à la réception d'informations d'adresse de rangées;
un dispositif d'adressage de colonnes (CB, CD) destiné à sélectionner l'une desdites paires de lignes de bits à la réception d'informations d'adresse de colonnes;
un amplificateur de lecture (SA) destiné à amplifier la différence de potentiel entr'une paire de lignes de bits sélectionnée par ledit dispositif d'adressage de colonnes;

un tampon de sortie (OB) connecté à la sortie dudit amplificateur de lecture pour maintenir et pour émettre un signal de sortie de données ($D_{OUT}$); et

un premier circuit générateur de signaux d'horloge ($CK_1$) destiné à détecter le changement desdites informations d'adresses de rangées et à produire un premier signal d'horloge ($CP_1$);

caractérisé en ce que le premier circuit générateur de signaux d'horloge ($CK_1$) détecte également un changement desdites informations d'adresses de colonnes;

en ce que le dispositif à mémoire comporte également:

un second circuit générateur de signaux d'horloge ($CK_2$) destiné à détecter le changement du potentiel desdites lignes de mots et à produire un second signal d'horloge ($CP_2$); et

un circuit d'attaque de mots (WD) destiné à activer ledit dispositif d'adressage de rangées, ledit dispositif d'attaque de mots étant mis en place par la transition croissante dudit premier signal d'horloge et ramené à zéro par la transition croissante dudit second signal d'horloge;

ledit dispositif d'adressage de rangées et ledit second circuit générateur de signaux d'horloge étant disposés à l'opposé l'un de l'autre et lesdites lignes de mots étant disposées entre eux.

2. Dispositif selon la revendication 1, dans lequel ledit tampon de sortie est commandé par ledit premier signal d'horloge, ledit tampon de sortie produisant un signal de potentiel de niveau haut à la réception dudit premier signal d'horloge qui est au niveau haut indépendamment du potentiel de sortie dudit amplificateur de lecture.

3. Dispositif selon la revendication 1 ou 2, comportant en outre un dispositif inverseur ($I_0$) connecté entre la sortie dudit second circuit générateur de signaux d'horloge et dudit dispositif de charge, pour bloquer ledit dispositif de charge à la réception d'un signal inversé de niveau bas ($CP_2$) dudit second signal d'horloge.

Fig. I

| Fig. I A | Fig. I B |

Fig. I A

*Fig. 1B*

## Fig. 2

Fig. 3A  PREVIOUS ADDRESS  CURRENT ADDRESS

Fig. 3B  CP₁

Fig. 3C  φ_W

Fig. 3D  X

Fig. 3E  CP₂

Fig. 3F  DB  $\overline{DB}$

Fig. 3G  SD  $\overline{SD}$

Fig. 3H  $\overline{D}$  D

Fig. 3I  D_OUT

Fig.4A

Fig.4B

Fig. 5A

Fig. 5B

# Fig. 6

# Fig. 7A

## Fig. 7B

## Fig. 7C

# Fig. 8A

# Fig. 8B

Fig. 9

| Fig. 9A | Fig. 9B |
|---------|---------|

Fig. 9A

EP 0 098 164 B1

Fig. 9B

11

Fig. IOA

PREVIOUS
ADDRESS

CURRENT
ADDRESS

Fig. IOB

$D$
$\bar{D}$

$\Delta t_3$

Fig. IOC

$D_{OUT}$

$t_0$        $t_1$ $t_2$   $t_3$   $t_4$

Fig.IIA

PREVIOUS
ADDRESS

CURRENT
ADDRESS

Fig.IIB  CP₁

Fig.IIC

Fig.IID  Dₒᵤₜ

13

# Fig. 12